## Europäisches Patentamt

## European Patent Office

## Office européen des brevets

(19)

(11) Veröffentlichungsnummer: **0 125 206**
**B1**

(12)

# EUROPÄISCHE PATENTSCHRIFT

(45) Veröffentlichungstag der Patentschrift:
**13.05.87**

(51) Int. Cl.⁴: **C 08 F 2/50**, G 03 C 1/68

(21) Anmeldenummer: **84810202.6**

(22) Anmeldetag: **27.04.84**

(54) **Flüssiges Photoinitiatorgemisch.**

(30) Priorität: **06.05.83 CH 2492/83**

(43) Veröffentlichungstag der Anmeldung:
**14.11.84 Patentblatt 84/46**

(45) Bekanntmachung des Hinweises auf die Patenterteilung:
**13.05.87 Patentblatt 87/20**

(84) Benannte Vertragsstaaten:
**BE DE FR GB IT NL**

(56) Entgegenhaltungen:
**US - A - 4 067 791**

(73) Patentinhaber: **CIBA-GEIGY AG, Klybeckstrasse 141,
CH-4002 Basel (CH)**

(72) Erfinder: **Berner, Godwin, Dr., Waldhofstrasse 70,
CH-4310 Rheinfelden (CH)**
Erfinder: **Manser, Aloysius Hubertus, Feldstrasse 93,
CH-4123 Allschwil (CH)**

## Beschreibung

Die Erfindung betrifft ein flüssiges Gemisch von Initiatoren für die Photopolymerisation ethylenisch ungesättigter Verbindungen und deren Verwendung für die Härtung photopolymerisierbarer Massen.

Es ist bekannt, dass man zur Beschleunigung der Photohärtung von Anstrichstoffen, Druckfarben, Photoresists und ähnlichen Systemen den photopolymerisierbaren Massen Photoinitiatoren zusetzt. Auf diese Weise ist es möglich, solche Massen in sehr kurzer Bestrahlungszeit so weit zu härten, dass ihre Oberfläche nicht mehr klebrig ist. Diese Massen enthalten als Bindemittel flüssige ethylenisch ungesättigte Verbindungen, die bei der Bestrahlung mit kurzwelligem Licht durch eine radikalische Polymerisation der ungesättigten Gruppen erhärten. Als Photoinitiatoren werden verschiedene Verbindungen verwendet; die meisten von ihnen sind photochemisch spaltbare aromatische Carbonylverbindungen, wie z.B. Benzoin, Benzoinether, Benzil, Benzilketale, Benzophenon und dessen Derivate oder Thioxanthon und dessen Derivate. In neuerer Zeit hat für bestimmte Anwendungsgebiete das 1-Benzoylcyclohexanol als Photoinitiator technische Verwendung gefunden, insbesondere für photopolymerisierbare Systeme auf Basis von Acrylsäurederivaten. 1-Benzoylcyclohexanol ist eine bei 50°C schmelzende kristalline Verbindung, die unter den Namen «Irgacure®184» im Handel ist. Wenn man diese Verbindung in die zumeist ölig-flüssigen oder pastösen photopolymerisierbaren Massen einmischen will, so benötigt man eine gewisse Zeit, bis sich die Verbindung vollständig aufgelöst hat. Man kann den Lösungsvorgang dadurch beschleunigen, dass man den festen Photoinitiator in gelöster Form einsetzt. Hierfür ist zusätzlich ein Lösungsmittel erforderlich, das nach dem Aufbringen der Masse entfernt werden muss.

Es wurde nunmehr gefunden, dass man das Problem dadurch lösen kann, dass man das 1-Benzoylcyclohexanol mit annähernd gleichen Teilen Benzophenon oder einen Benzophenonderivat, das unterhalb 80°C schmilzt, vermischt. Diese Gemische sind in einem gewissen Mischungsbereich flüssig und lassen sich daher einfach und schnell in flüssige oder pastöse Massen einarbeiten. Diese Mischungen zeichnen sich ausserdem überraschenderweise durch eine hohe Initiatoraktivität aus. Die Aktivität dieser Mischungen, die man durch Messung der zur Härtung nötigen Bestrahlungszeit messen kann, liegt höher als die der einzelnen Komponenten, man kann hier also von einem Synergismus sprechen.

Die Erfindung betrifft daher ein flüssiges Gemisch von Photoinitiatoren, bestehend aus 40-60 Gew.-% 1-Benzoylcyclohexanol und 60-40 Gew.-% Benzophenon oder eines unterhalb 80°C schmelzenden Benzophenonderivates.

Bevorzugt sind Gemische im Gewichtsverhältnis 45-55%:55-45%, insbesondere Gemische im Gewichtsverhältnis von 50:50%.

Beispiele für erfindungsgemäss verwendbare Benzophenonderivate sind:

a) Alkylderivate wie z.B. das 2-Methyl-, 4-Methyl-, 2,4-Dimethyl-, 3,4-Dimethyl-, 4-Isopropyl- oder 4-Dodecylbenzophenon,

b) Halogenderivate, insbesondere Chlorderivate wie z.B. das 2-Chlor-, 4-Chlor- oder 2,2'-Dichlorbenzophenon,

c) Alkoxy- und Alkylthioderivate, wie z.B. das 2-, 3- oder 4-Methoxy-, 2- oder 4-Methylthio-, 2-Ethoxy-, 4-Propoxy-, 4-Butoxy- oder 4-Isopropoxybenzophenon,

d) Carbonesterderivate, wie z.B. das 2-Methoxycarbonyl-, 3-Methoxycarbonyl-, 2- oder 4-Ethoxycarbonyl-, 2- oder 4-Isopropoxycarbonyl-, 4-tert.-Butoxycarbonyl-, 2-Butoxycarbonyl- oder 2,2'-Di(ethoxycarbonyl)benzophenon.

Bevorzugt sind Gemische von 1-Benzoylcyclohexanol und Benzophenon.

Die erfindungsgemässen Gemische sind bei Raumtemperatur flüssig und erstarren auch bei längerer Lagerung nicht. Dies sei am Beispiel von Gemischen von 1-Benzoylcyclohexanol und Benzophenon in verschiedenen Gewichtsverhältnissen gezeigt. Die Gemische wurden 30 Tage in einem Kühlschrank bei 5-8°C gelagert und täglich auf beginnende Kristallisation (Trübung) visuell kontrolliert. Hierbei ergaben sich folgende Resultate:

| Gew.-% 1-Benzoylcyclohexanol | Gew.-% Benzophenon | Kristallisation nach |
|---|---|---|
| 95 | 5 | < 1 d |
| 90 | 10 | 3 d |
| 80 | 20 | 3 d |
| 70 | 30 | 20 d |
| 65 | 35 | > 30 d |
| 60 | 40 | > 30 d |
| 55 | 45 | > 30 d |
| 50 | 50 | > 30 d |
| 45 | 55 | > 30 d |
| 40 | 60 | 19 d |
| 30 | 70 | 6 d |
| 20 | 80 | 2 d |
| 10 | 90 | < 1 d |

[d = day(s) = Tag(e)]

Man ersieht daraus, dass in einem mittleren Gewichtsbereich (65:35 bis 45:55%) innerhalb der Beobachtungszeit keine Kristallisation eintritt.

Die erfindungsgemässen Gemische können auch noch weitere Zusatzstoffe enthalten, sofern dadurch der Schmelzpunkt der Gemische nicht wesentlich erhöht wird. Solche Zusatzstoffe können weitere Photoinitiatoren oder Härtungsbeschleuniger sein, es können Polymerisationsinhibitoren sein, die die Dunkellagerstabilität des Lackes erhöhen, es können Lichtschutzmittel oder UV-Absorber sein oder Verlaufhilfsmittel oder andere in der Lacktechnologie übliche Zusatzstoffe. Von besonderer Bedeutung ist der Zusatz von Phosphorigsäureestern, die als Härtungsbeschleuniger und Antioxydantien wirken. Hierbei sind flüssige Phosphite von längerkettigen Alkoholen, insbesondere $C_{10}$-$C_{14}$-Alkoholen, bevorzugt. Beispiele hierfür sind Tridecylphosphat, Tridodecylphosphat, Tri-(isodecyl)phosphat oder Tri-(tetradecyl)phosphat. Auch gemischte Phosphite von 2 oder 3 längerkettigen Alkoholen können hierfür verwendet werden.

Die Menge des Phosphit-Zusatzes beträgt vorzugsweise 2-10 Gew.-%, bezogen auf die Summe der Photoinitiatoren.

Von besonderer Bedeutung ist weiterhin der Zusatz von Lichtschutzmitteln aus der Reihe der sterisch gehinderten Amine. Auch hier sind flüssige Verbindungen bevorzugt. Beispiele hierfür sind das Bis-(1,2,2,6,6-pentamethyl-4-piperidinyl)-sebacat oder dessen Gemisch mit Monoethyl-mono(1,2,2,6,6--pentamethyl-1-piperidinyl)-sebacat, wie es als Tinuvin®292 im Handel ist.

Die Menge des Zusatzes an sterisch gehindertem Amin beträgt vorzugsweise 10-20 Gew.-%, bezogen auf die Summe der Photoinitiatoren.

Die photopolymerisierbaren Massen, die man unter Verwendung der erfindungsgemässen Initiatorgemische härten kann, enthalten eine oder mehrere ethylenisch ungesättigte Verbindungen. Diese können niedermolekular (monomer) oder höhermolekular (oligomer) sein, sie können eine oder mehrere Doppelbindungen enthalten.

Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol-, oder Bisphenol-A-diacrylat, 4,4'-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanat oder Tris(2-acryloyloxyethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Die photopolymerisierbaren Massen können z.B. Gemische eines einfach ungesättigten mit einem mehrfach ungesättigten Monomeren sein. Häufiger verwendet man jedoch Gemische eines mehrfach ungesättigten Monomeren mit einem ungesättigten Oligomer (Prepolymer). Auch Dreikomponenten-Gemische dieser Art werden häufig verwendet. Das Prepolymere ist hierbei in erster Linie für die Eigenschaften des Polymerisates massgebend, durch seine Variation kann der Fachmann die Eigenschaften des gehärteten Filmes beeinflussen. Das mehrfach ungesättigte Monomere fungiert als Vernetzer, das das Polymer unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Solche Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide oder Polychalkone.

Die photopolymerisierbare Masse kann ausserdem kleinere Anteile an nicht-photopolymerisierbaren filmbildenden Komponenten enthalten. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Massen können — je nach ihrem Verwendungszweck — eine Reihe sonstiger Zusätze enthalten. Beispiele hierfür sind thermische Inhibitoren, die eine Polymerisation von der Bestrahlung verhindern und damit die Lagerstabilität erhöhen sollen, Härtungsbeschleuniger wie tertiäre Amine, Antioxydantien, Lichtschutzmittel oder Verlaufhilfsmittel.

Weiters können die photopolymerisierbaren Massen Füllstoffe wie Kieselsäure, Talkum oder Gips, Pigmente, Farbstoffe oder Fasern enthalten.

Die wichtigsten Anwendungsgebiete der Photopolymerisation sind die der Lacke und Druckfarben, der Herstellung von Photoresists und der Herstellung von Druckplatten. Die erfindungsgemässen Photoinitiator-Gemische werden den photopolymerisierbaren Verbindungen in einer Menge von 0,1 bis 20 Gew.-%, insbesondere 0,5 bis 5 Gew.-%, zugesetzt.

Von besonderer Bedeutung sind die erfindungsgemässen Photoinitiatoren für die Verwendung in Klarlacken wie sie zur Lackierung von Artikeln aus Metall, Kunststoffen, Holz oder Papier verwendet werden, da hierbei die Transparenz nicht durch Rekristallisation des Inhibitors vermindert werden kann.

Photopolymerisierbare Lacke können auch wasserverdünnbare Lacke sein, wie sie beispielsweise in der EP 12 339 und in der DE-OS 30 05 036 beschrieben werden. Solche Lacke bilden in Wasser eine Dispersion oder Emulsion. Hierbei ist es von Vorteil, wenn der zugesetzte Photoinitiator flüssig ist, da sich organische Flüssigkeiten in Wasser besser verteilen lassen als Feststoffe. Auch für elektrisch abscheidbare Lacke, die ja im wässrigen Medium appliziert werden, eignen sich aus diesem Grunde flüssige Photoinitiatoren besser als feste.

Der Zusatz der flüssigen Photoinitiatorgemische zur photopolymerisierbaren Masse geschieht durch einfaches Einrühren in die Masse. In kurzer Zeit ist eine homogene Verteilung erreichbar.

Die Polymerisation der Massen erfolgt nach den bekannten Methoden der Photopolymerisation durch Bestrahlung mit Licht, das reich an kurzwelliger Strahlung ist. Als Lichtquellen sind z.B. Quecksilbermitteldruck-, -hochdruck- und -niederdruckstrahler, sowie superaktinische Leuchtstoffröhren geeignet, deren Emissionsmaxima im Bereich zwischen 250 und 400 nm liegen.

Durch Zusatz von Photosensibilisatoren kann die spektrale Empfindlichkeit in bestimmte Bereiche verschieben, so dass man auch mit relativ langwelligen Lampen arbeiten kann. Beispiele für solchen Photosensibilisatoren sind organische Farbstoffe oder mehrkernige kondensierte aromatische Verbindungen wie z.B. Perylen, Anthracen-Derivate oder Thioxanthon-Derivate.

Die folgenden Beispiele erläutern die Erfindung näher und zeigen die Verwendung der erfindungsgemässen Initiatorgemische in verschiedenen Substraten. Teile bedeuten Gewichtsteile und % bedeuten Gewichts-%.

*Beispiel 1:*
Härtung eines Klarlackes auf Acrylatbasis

Es wurde ein lösungsmittelfreier Lack auf folgender Rezeptur hergestellt:

50 Teile eines Urethanacrylates (Ebecryl®204, UCB, Belgien)
19 Teile eines Epoxidacrylates (XD 4074, Ciba-Geigy, UK)
19 Teile Butandioldiacrylat
11 Teile N-Vinylpyrrolidon
0,5 Teile eines Verlaufshilfsmittels auf Basis eines Silikonharzes (Byk®3000, Byk-Mallinckrodt, BRD)
0,5 Teile eines Verlaufshilfsmittels (Blisterfree®, B. Schwegmann, BRD).

Die Komponenten werden in einem Disolver zusammengemischt. Dann fügt man die in den Tabellen angegebenen Mengen an Photoinitiatoren zu und mischt nochmals 10-15 Min. bei 50-60°C.

Zur Bestimmung der Härtungsgeschwindigkeit werden die Proben auf Glasplatten in einer Filmstärke von 60 μm aufgetragen und in einem PPG-Bestrahlungsgerät mit einer Hochdruck-Quecksilberdampflampe von 80 W/cm bestrahlt. Die Proben werden dabei so oft durch das Gerät transportiert, bis die Oberfläche wischfest ist. Ein Durchgang entspricht einer Bestrahlungszeit von 2,1 sek, aus der Anzahl der Durchgänge ermittelt sich die minimale Bestrahlungszeit $T_{min}$, die in der Tabelle aufgeführt ist.

Zur Kontrolle der Durchhärtung wird von der in der minimalen Belichtungszeit gehärteten Probe nach 30 Minuten Lagerung die Pendelhärte nach Koenig (DIN 53157) bestimmt. Die Ergebnisse sind in Tabelle 1 aufgeführt.

*Tabelle 1*

| Photoinitiator*) | | Phosphit*) | Lichtschutz-mittel*) | | $T_{min}$ in Sek. | Pendelhärte (in Sek.) |
|---|---|---|---|---|---|---|
| Gemisch 1 | 0,5% | — | — | | 27,3 | 110 |
| | 1% | — | — | | 21,0 | 150 |
| | 2% | — | — | | 10,5 | 150 |
| | 5% | — | — | | 4,2 | 140 |
| Gemisch 1 | 0,5% | TDP 0,5% | — | | 25,2 | 100 |
| | 1% | » | — | | 14,7 | 150 |
| | 2% | » | — | | 8,4 | 150 |
| | 5% | » | — | | 4,2 | 140 |
| Gemisch 1 | 0,5% | TDP 0,5% | LS 292 | 1% | 31,5 | 100 |
| | 1% | » | » | | 16,8 | 140 |
| | 2% | » | » | | 8,4 | 150 |
| | 5% | » | » | | 4,2 | 150 |

*) Menge in Gew.-% bezogen auf den Lack
Gemisch 1 = 50% 1-Benzoylcyclohexanol + 50% Benzophenon
Phosphite: TDP = Tridecylphosphit
Lichtschutzmittel: LS 292 = Bis(1,2,2,6,6-pentamethyl-4-piperidyl)-sebacat

In analoger Weise werden weisse Kartonblätter mit einem 7 μm starken Film der Proben beschichtet und bis zur Wischfestigkeit bestrahlt. Von den gehärteten Proben wurde der Yellowness-Index (YI) in einem Hunter-Photometer gemessen. Die Ergebnisse sind in Tabelle 2 aufgeführt.

*Tabelle 1*

| Photoinitiator | | Phosphit | Lichtschutz-mittel | | $T_{min}$ in Sek. | YI |
|---|---|---|---|---|---|---|
| Gemisch 1 | 0,5% | — | — | | 31,5 | 11 |
| | 1% | — | — | | 29,4 | 10 |
| | 2% | — | — | | 14,7 | 11 |
| | 5% | — | — | | 6,3 | 10 |
| Gemisch 1 | 0,5% | TDP 0,5% | — | | 29,4 | 11 |
| | 1% | » | — | | 23,1 | 10 |
| | 2% | » | — | | 12,6 | 10 |
| | 5% | » | — | | 6,3 | 11 |
| Gemisch 1 | 0,5% | TDP 0,5% | LS 292 | 1% | 31,5 | 9 |
| | 1% | » | » | | 29,4 | 9 |
| | 2% | » | » | | 16,8 | 9 |
| | 5% | » | » | | 6,3 | 9 |

Man ersieht aus den Tabellen, dass der Zusatz eines Phosphites die Härtungsgeschwindigkeit geringfügig erhöht, jedoch die Eigenschaften des gehärteten Lackfilmes nicht verändert. Der Zusatz eines Lichtschutzmittels vom Typ der sterisch gehindertem Amine verzögerte die Härtung geringfügig, verringert jedoch die bei der Bestrahlung eintretende geringe Vergilbung.

**Patentansprüche**

1. Flüssiges Gemisch von Photoinitiatoren, bestehend aus 40-60 Gew.-% 1-Benzoylcyclohexanol und 60-40 Gew.-% Benzophenon oder eines unterhalb 80°C schmelzenden Benzophenonderivates.

2. Gemisch nach Anspruch 1, bestehend aus 45-55 Gew.-% 1-Benzoylcyclohexanol und 55-45 Gew.-% Benzophenon oder eines Benzophenonderivates, insbesondere solche Gemische im Gewichtsverhältnis 50:50%.

3. Gemisch nach Anspruch 1, worin das Benzophenonderivat ein durch eine oder mehrere Alkyl-, Halogen-, Alkoxy-. Alkylthio- oder Alkoxycarbonylgruppen substituiertes Benzophenon ist.

4. Gemisch nach Anspruch 1, bestehend aus 1-Benzoylcyclohexanol und Benzophenon.

5. Gemisch nach Anspruch 1, enthaltend zusätzlich 2-10 Gew.-% eines Phosphorigsäureester und/oder 10-20 Gew.-% eines Lichtschutzmittels aus der Reihe der sterisch gehinderten Amine, wobei sich die Gew.-% auf die Summe der Photoinitiatoren beziehen.

6. Verwendung der Gemisches des Anspruchs 1 als Photoinitiatoren für die Photohärtung photopolymerisierbarer Massen, die eine oder mehrere ethylenisch ungesättigte Verbindungen enthalten.

7. Verwendung gemäss Anspruch 6 für die Photohärtung von Massen, die eine oder mehrere Acrylverbindungen enthalten.

8. Photopolymerisierbare Masse auf Basis einer oder mehrerer ethylenisch ungesättigter Verbindungen, enthaltend 0,1 bis 20, insbesondere 0,5 bis 5 Gew.-% eines flüssigen Initiatorgemisches gemäss Anspruch 1.

9. Photopolymerisierbarer Klarlack gemäss Anspruch 8 für die Lackierung von Metallen, Kunststoffen, Holz oder Papier.

10. Photopolymerisierbarer wasserverdünnbarer Lack gemäss Anspruch 9.

**Claims**

1. A liquid mixture of photoinitiators which consists of 40-60% by weight of 1-benzoylcyclohexanol and 60-40% by weight of benzophenone or of a benzophenone derivative melting below 80°C.

2. A mixture according to claim 1, which consists of 45-55% by weight of 1-benzoylcyclohexanol and 55-45% by weight of benzophenone or of a benzophenone derivative, in particular such a mixture in a weight ratio of 50:50%.

3. A mixture according to claim 1, wherein the benzophenone derivative is a benzophenone substituted by one or more alkyl, halogen, alkoxy, alkylthio or alkoxycarbonyl groups.

4. A mixture according to claim 1, which consists of 1-benzoylcyclohexanol and benzophenone.

5. A mixture according to claim 1, which additionally contains 2-10% by weight of a phosphorous acid ester and/or 10-20% by weight of a light stabiliser from the series of sterically hindered amines, the % by weight values relating to the total amount of photoinitiators.

6. Use of a mixture according to claim 1 as photoinitiator for the photocuring of photopolymerisable compositions which contain one or more ethylenically unsaturated compounds.

7. Use according to claim 6 for the photocuring of compositions which contain one or more acrylic compounds.

8. A photopolymerisable composition based on one or more ethylenically unsaturated compounds, which contains 0.1 to 20% by weight, particularly 0.5 to 5% by weight, of a liquid initiator mixture according to claim 1.

9. A photopolymerisable clear lacquer according to claim 8 for the lacquering of metals, plastics, wood and paper.

10. A photopolymerisable, water-dilutable lacquer according to claim 9.

**Revendications**

1. Mélange liquide de photo-amorceurs qui est constitué de 40 à 60% en poids de benzoyl-1 cyclohexanol et de 60 à 40% en poids de benzophénone ou d'un dérivé de la benzophénone fondant au-dessous de 80°C.

2. Mélange selon la revendication 1 qui est constitué de 45 à 55% en poids de benzoyl-1 cyclohexanol et de 55 à 45% en poids de benzophénone ou d'un dérivé de la benzophénone, plus particulièrement de 50% en poids du premier constituant et de 50% en poids du second.

3. Mélange selon la revendication 1 dans lequel le dérivé de la benzophénone est une benzophénone qui porte un ou plusieurs substituants pris dans l'ensemble constitué par les alkyles, les halogènes, les alcoxy, les alkylthio et les alcoxycarbonyles.

4. Mélange selon la revendication 1 constitué de benzoyl-1 cyclohexanol et de benzophénone.

5. Mélange selon la revendication 1 qui contient en outre de 2 à 10% en poids d'un ester de l'acide phosphoreux et/ou de 10 à 20% en poids d'un stabilisant à la lumière de la série des amines à empêchement stérique, les pourcentages pondéraux étant rapportés à la somme des photo-amorceurs.

6. Application du mélange selon la revendication 1 comme photo-amorceur pour le photo-durcissement de matières photopolymérisables contenant un ou plusieurs composés éthyléniques.

7. Application selon la revendication 6 pour le photo-durcissement de matières contenant un ou plusieurs composés acryliques.

8. Matière photopolymérisable à base d'un ou de plusieurs composés éthyléniques, matière qui contient de 0,1 à 20% en poids, plus spécialement de 0,5 à 5% en poids, d'un mélange liquide d'amorceurs selon la revendication 1.

9. Vernis photopolymérisable selon la revendication 8 pour le vernissage de métaux, de matières plastiques, du bois ou du papier.

10. Vernis photopolymérisable et diluable à l'eau selon la revendication 9.